(19) Europäisches Patentamt
European Patent Office
Office européen des brevets

(11) **EP 2 599 107 B1**

(12) **EUROPEAN PATENT SPECIFICATION**

(45) Date of publication and mention
of the grant of the patent:
**21.12.2016 Bulletin 2016/51**

(21) Application number: **11810872.9**

(22) Date of filing: **26.07.2011**

(51) Int Cl.:
*H01L 21/20* (2006.01)      *H01L 29/739* (2006.01)
*H01L 29/78* (2006.01)       *H01L 29/06* (2006.01)
*H01L 29/66* (2006.01)

(86) International application number:
**PCT/IB2011/001724**

(87) International publication number:
**WO 2012/020290 (16.02.2012 Gazette 2012/07)**

(54) **PROCESS FOR FILLING DEEP TRENCHES IN A SEMICONDUCTOR MATERIAL BODY**

VERFAHREN ZUM FÜLLEN TIEFER GRÄBEN IN EINEM HALBLEITERMATERIALKÖRPER

PROCÉDÉ DE REMPLISSAGE DE TRANCHÉES PROFONDES DANS UN CORPS DE MATÉRIAU SEMI-CONDUCTEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.07.2010 IT TO20100642**

(43) Date of publication of application:
**05.06.2013 Bulletin 2013/23**

(73) Proprietor: **STMicroelectronics S.r.l.
20864 Agrate Brianza (MB) (IT)**

(72) Inventors:
• **SAGGIO, Mario, Giuseppe
I-95021 Acicastello (IT)**
• **MURABITO, Domenico
I-95128 Catania (IT)**
• **FIORE, Letterio
I-98168 Messina (IT)**
• **MORALE, Giuseppe
I-95124 Catania (IT)**
• **ARENA, Giuseppe
I-95125 Catania (IT)**

(74) Representative: **Nannucci, Lorenzo
Studio Torta S.p.A.
Via Viotti, 9
10121 Torino (IT)**

(56) References cited:
**JP-A- 2006 352 092**

• **YAMAUCHI S ET AL: "200V super junction
MOSFET fabricated by high aspect ratio trench
filling", PROCEEDINGS OF THE 18TH
INTERNATIONAL SYMPOSIUM ON POWER
SEMICONDUCTOR DEVICES & ICS (IEEE CAT.
NO. 06CH37817C) IEEE PISCATAWAY, NJ, USA,
2006, page 4 PP., XP002620529, ISBN:
0-7803-9714-2**
• **YAMAUCHI S ET AL: "Fabrication of high aspect
ratio doping region by using trench filling of
epitaxial Si growth", PROCEEDINGS OF THE
13TH INTERNATIONAL SYMPOSIUM ON POWER
SEMICONDUCTOR DEVICES, 4 June 2001
(2001-06-04), pages 363-366, XP002620530,
Osaka DOI: 10.1109/ISPSD.2001.934630 ISBN:
4-88686-056-7**
• **Sorab K. Ghandi: "VLSI Fabrication Principles",
1 January 1983 (1983-01-01), Wiley, New York,
XP002620531, ISBN: 0-471-86833-7 the whole
document**

**Description**

TECHNICAL FIELD

The present invention relates to a process for filling deep trenches in a semiconductor material body of a semiconductor device. In particular, the present disclosure will make explicit reference, without this implying any loss in generality, to a semiconductor power device (for example a diode, a MOSFET, an IGBT, or a bipolar transistor) of the charge-balance type.

BACKGROUND ART

As is known, a wide range of solutions have been developed in recent years to increase the efficiency of semiconductor power devices, in particular in terms of increase in the corresponding breakdown voltage and reduction in the corresponding output resistance.

For instance, U.S. US 6,586,798, US 6,228,719, US 6,300,171 and US 6,404,010 disclose vertical-conduction semiconductor power devices, in which, within an epitaxial layer, which forms part of a drain region having a given type of conductivity (for example a conductivity of an N type), columnar structures of opposite conductivity (in the example a conductivity of a P type) are provided. The columnar structures have a concentration of dopant such as to balance the amount of charge of the epitaxial layer in such a way as to create a substantial charge balance (so-called multi-drain (MD) technology or superjunction (SJ) technology).

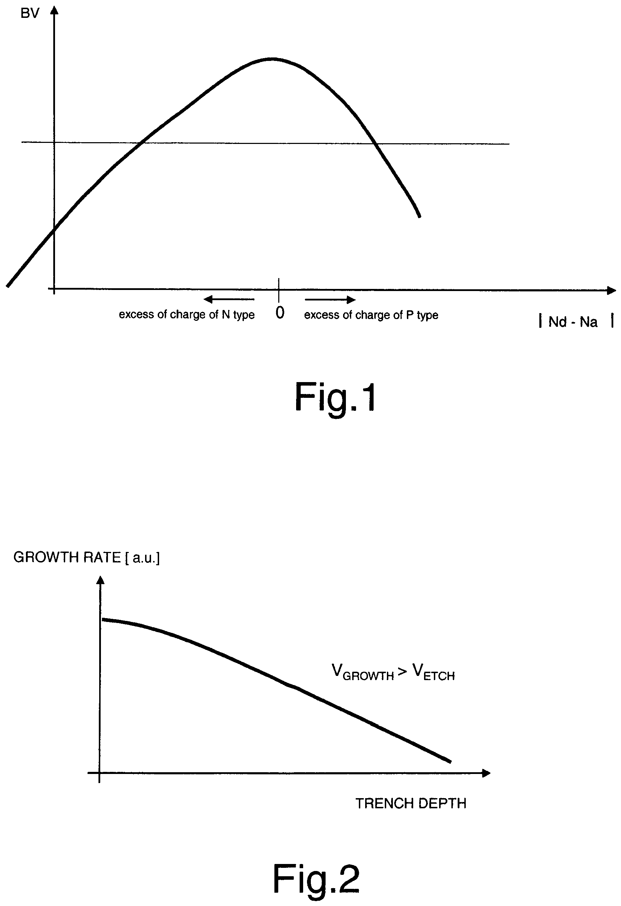

This charge balance enables high breakdown voltages to be obtained, as illustrated in the graph of Figure 1, which highlights that the value of the breakdown voltage (BV) of a semiconductor device has a maximum at a point corresponding to a perfect charge balance in the corresponding drain layer (Nd and Na the concentration of dopant species of a P type). In addition, the high concentration of the epitaxial layer enables a low output resistance (and hence low conduction losses) to be obtained.

Manufacturing of the columnar structures may envisage a sequence of steps of growth of epitaxial layers, for example of an N type, each step being followed by a step of implantation of dopant of an opposite type, in this case of a P type. The implanted regions are stacked so as to form the columnar structures. Next, in order for the columnar structure constituted by the alternation of implantations and epitaxial growths to be continuous, it is required to increase the thermal budget of the device. Finally, body regions of the power device are provided in contact with the columnar structures, in such a way that the columnar structures constitute an extension of the body regions within the drain region.

The evolution of this technology has led to a progressive increase in the density of the elementary strips that make up the devices in order to increase further the concentration of charge of the epitaxial layer and obtain devices that, given the same breakdown voltage (linked substantially to the height of the columnar structures), have a lower output resistance. On the other hand, however, the increase in the density of the elementary strips has led to a corresponding increase in the number of the steps of epitaxial growth (up to a number even greater than ten) and of the thermal budget of the resulting devices, and consequently an increase in the manufacturing costs and the time involved, as well as in the defectiveness (which is intrinsically linked to the steps of epitaxial growth).

Alternative techniques for manufacturing charge-balance columnar structures have consequently been developed, which envisage in particular formation of deep trenches within a surface portion of a wafer of semiconductor material, for example through a corresponding epitaxial layer, and subsequent filling of the same trenches with semiconductor material appropriately doped to obtain a charge balance.

For instance, solutions have been proposed in which the trenches are filled via steps of non-selective epitaxial growth of semiconductor material, alternated with distinct and separate steps of etching of surface growth portions (so-called "multi-step process").

As a whole, the solutions described for manufacturing of power devices with charge-balance structures have not proven altogether satisfactory, both as regards the complexity and costs of production and as regards obtaining a real charge balance (for instance, on account of a poor uniformity of spatial distribution of charge or on account of the presence of residual defects, in particular voids in filling of the trenches).

In particular, the steps of epitaxial filling of the deep trenches have proven critical, especially in the case where the same trenches have high values of aspect ratio or shape factor, i.e. high ratios between depth and width.

In fact, as highlighted in Figure 2, the rate of epitaxial growth ($V_{growth}$) decreases the greater the depth in the trench and the further the distance from the surface of the wafer of semiconductor material, as a consequence of the reduction in the concentration of reaction gases with depth. Consequently, the fronts of growth on the side walls of the trench at the surface may meet before filling of the trench itself has been completed; once the filling process is completed, voids may thus remain within the trenches that have been filled. These voids have dimensions that in some cases may even be large and voids have dimensions that in some cases may even be large and comparable with the width of the same trenches.

The presence of these voids, and in general of residual defects in the filled trenches, may jeopardize the electrical characteristics of the resulting semiconductor devices, for instance the electrical characteristics in the reverse-biasing region.

Yamauchi S et al: "200V Fabrication of high aspect ratio doping region by using trench filling of epitaxial SI growth", PROCEEDINGS OF THE 13TH INTERNATIONAL SYMPOSIUM ON POWER SEMICONDUCTOR DEVICES, 4 June 2001, Osaka, pages 363-366, discloses a multi-step process for filling a high aspect ratio trench with a reduced void size, alternating low-temperature epitaxial growth steps with high-temperature etching steps.

Yamauchi S et al: "200V super junction MOSFET fabricated by high aspect ratio trench filling", PROCEEDINGS OF THE 18TH INTERNATIONAL SYMPOSIUM ON POWER SEMICONDUCTOR DEVICES & ICS, IEEE PISCATAWAY, NJ, USA, 2006, page 4, discloses filling of a high aspect ratio trench using an anisotropic epitaxial growth, where a chlorine source gas is used to prevent the silicon epitaxial growth at the top of the trench, while a silicon epitaxial layer is grown from the bottom of the trench.

DISCLOSURE OF INVENTION

The aim of the present invention is thus to solve, either totally or partially, the problems highlighted previously, and in particular to provide a manufacturing process that will enable devices with improved electrical characteristics to be obtained and that will have a good degree of simplicity of production and contained manufacturing costs.

Consequently, according to the present invention, a process for manufacturing a semiconductor device is provided as defined in the annexed claims.

BRIEF DESCRIPTION OF THE DRAWINGS

For a better understanding of the present invention, preferred embodiments thereof are now described, purely by way of nonlimiting example and with reference to the attached drawings, wherein:

- Figures 1 and 2 show graphs of electrical and physical quantities regarding semiconductor devices and manufacturing processes of a conventional type;
- Figures 3a-3g show schematic cross sections of a body made of semiconductor material, during a process for filling deep trenches, according to one embodiment of the present invention;
- Figure 4 shows plots of rates of growth and etching adopted during substeps of the filling process illustrated in Figures 3a-3g;
- Figure 5 shows plots of ratios of flows of gases employed 3a-3g;
- Figures 6a-6g show schematic cross sections of a body made of semiconductor material, during a process for filling deep trenches, according to a different embodiment of the present invention;
- Figures 7 and 8 show schematic cross sections of a semiconductor device provided at the end of the process of filling of the deep trenches;
- Figures 9a and 9b show, respectively, a cross section and a top plan view, of an edge-termination structure of the semiconductor device of Figure 8, in a first variant embodiment; and
- Figures 10a and 10b show, respectively, a cross section and a top plan view, of an edge-termination structure of the semiconductor device of Figure 8, in a second variant embodiment.

BEST MODE FOR CARRYING OUT THE INVENTION

A manufacturing process according to one embodiment of the present invention is now described, with particular reference to the manufacturing of a charge-balance semiconductor device, in which columnar structures having a given conductivity are formed within a body made of semiconductor material of opposite conductivity, for balancing the overall charge thereof. It is to be noted, however, that the process that will be described finds general application for providing uniform filling, free from defects (namely, voids), of trenches previously made within a body of semiconductor material.

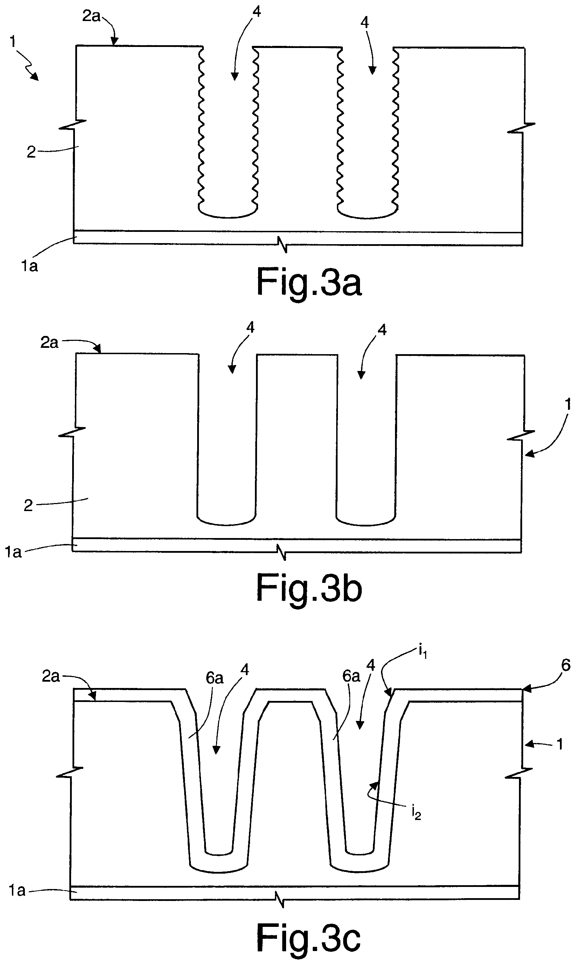

Figure 3a (not drawn to scale, as neither are the subsequent figures) shows a wafer 1 of semiconductor material, in particular silicon, including a substrate 1a and a structural layer 2, set on the substrate 1a and having a first type of conductivity, for example of an N type, and a top surface 2a; for instance, the structural layer 2 is an epitaxial layer previously grown on the substrate 1a.

Deep trenches 4 extend vertically (i.e., in the direction transverse to the cross section of Figure 3a) through a surface portion of the structural layer 2, in the direction of the depth of said structural layer 2 (towards the underlying substrate 1a). The deep trenches 4 are, for example, obtained with photolithographic techniques of masking and anisotropic dry chemical etching (not described in detail herein).

Figure 3a, as also the subsequent figures, shows for greater clarity an enlargement of a surface portion of the wafer 1, which encloses a single pair of mutually adjacent deep trenches 4 (in a position corresponding to which two corresponding strips of a semiconductor device will be formed, as clarified hereinafter). It is, however, clear that the process steps described hereinafter also regard the remaining part of the wafer 1.

Deep trenches 4 have substantially vertical side walls (orthogonal to the top surface 2a), with an angle of inclination, with respect to the same top surface 2a, comprised, for example between 88° and 90°, and a high aspect ratio. For instance, the deep trenches 4 have a depth of 30 $\mu$m and a width of between 1.5 $\mu$m and 3 $\mu$m; or else a depth of 10 $\mu$m and a width of between 0.5 $\mu$m and 1.5 $\mu$m (the corresponding depth thus being, for instance, ten to twenty times the corresponding width).

As is known, the depth of the deep trenches 4 determines the voltage class of the resulting semiconductor device. For instance, to a depth of 5 $\mu$m there corresponds a voltage class of 100 V, whereas to a depth of 30 $\mu$m there corresponds a voltage class of 600 V. The cutoff voltage of the resulting semiconductor device may moreover vary as a function of the thickness of the structural layer 2; for instance, the cutoff voltage of the resulting device may vary between 100 V and 1500 V, according to the thickness of the structural layer 2.

In addition, the distance of lateral separation (measured parallel to the top surface 2a and transverse to the direction of the depth) between two adjacent deep trenches 4 is, for example, between 3 $\mu$m and 6 $\mu$m; this separation distance, together with the width of the same deep trenches 4, defines the periodicity of the structure of the final semiconductor device (which is, in fact, made up of a plurality of elementary structures).

As illustrated in Figure 3b, the process proceeds with a step of surface treatment of the internal side walls of the deep trenches 4, in particular including a thermal treatment of annealing in hydrogen environment at a high temperature (for instance, from 1000°C to 1150°C). This treatment enables removal of damages due to the previous dry etching (which has led to formation of the deep trenches 4) and moreover possible removal of surface roughness on the side walls (so-called "scallops"). In the same process step, there is moreover obtained removal of possible oxide formed in the previous process steps on the side walls, which at the end of this step are hence smooth and uniform.

In particular, the aforesaid annealing may be carried out in the same reactor as the one in which the epitaxial growth for filling the deep trenches 4 will then be carried out.

The process proceeds then with filling of the deep trenches 4, in particular through a uniform epitaxial filling free from voids of the same deep trenches with monocrystalline silicon doped with a second type of conductivity, in the example described, of a P type (for instance doped with boron ions).

In particular, in order to obtain a uniform filling of the deep trenches 4, one aspect of the present invention envisages use, within the reaction environment for the epitaxial growth of an appropriate chemical-etching agent mixed to the source gas used for the epitaxial growth, the chemical-etching agent being able to modulate appropriately the rate of epitaxial growth. There is thus obtained an appropriate dynamic balance between the epitaxial growth along the walls of the deep trenches 4 and the simultaneous removal of part of the layer grown, and possibly of pre-existing material, by means of chemical etching, in order to obtain homogeneously filled columnar structures. In other words, the invention proposes an *in situ* balance (i.e., a balance obtained within the same environment of epitaxial growth) of the growth and of the simultaneous etching of an epitaxial layer, such as to modulate appropriately and dynamically the shape of the regions of material grown and of the deep trenches 4 in the filling step, and thus obtain a uniform filling of the same deep trenches 4.

For instance, the present invention envisages the use, as a chemical-etching agent, of hydrochloric acid (HC1), appropriately supplied in the reaction environment together with the silicon source gas constituted by dichlorosilane (DCS - $SiH_2Cl_2$). As already highlighted, the role of hydrochloric acid (HCl) is to modulate appropriately the rate of epitaxial growth, for instance in such a way that the epitaxial growth increases in the deep trenches 4 the further the distance from the surface (hence reversing the profile provided by the epitaxial growth alone - see Figure 2).

In the reaction environment there is also present a carrier gas, which enables modulation of the partial pressure of the reagent species and participates also in the overall reaction of epitaxial growth; by way of example, molecular hydrogen ($H_2$) may be used as such a carrier gas.

As described in detail hereinafter, within the same reaction chamber for the epitaxial growth an appropriate doping agent is moreover supplied, such as to enable a desired dopant profile to be obtained within the columnar structure that is formed within each deep trench 4. For instance, for this purpose an appropriate flow of diborane ($B_2H_6$) is used, which is able to form a dopant of a P type within the columnar structures being formed inside the deep trenches 4.

According to a peculiar aspect of the present invention, the step of epitaxial growth for filling the deep trenches 4 is articulated in a sequence of substeps, in each of which the process conditions, and in particular the flows of the various gases that participate in combination in the resulting growth, are varied. Within the various substeps, during the epitaxial process, the competitive behaviour of the etching agent (in the example, HCl) and of the growth agent (in the example, DCS) is appropriately exploited so as to modulate the shape of the deep trenches 4 and of the material grown within the same deep trenches 4, and prevent formation of defects (in particular, residual voids).

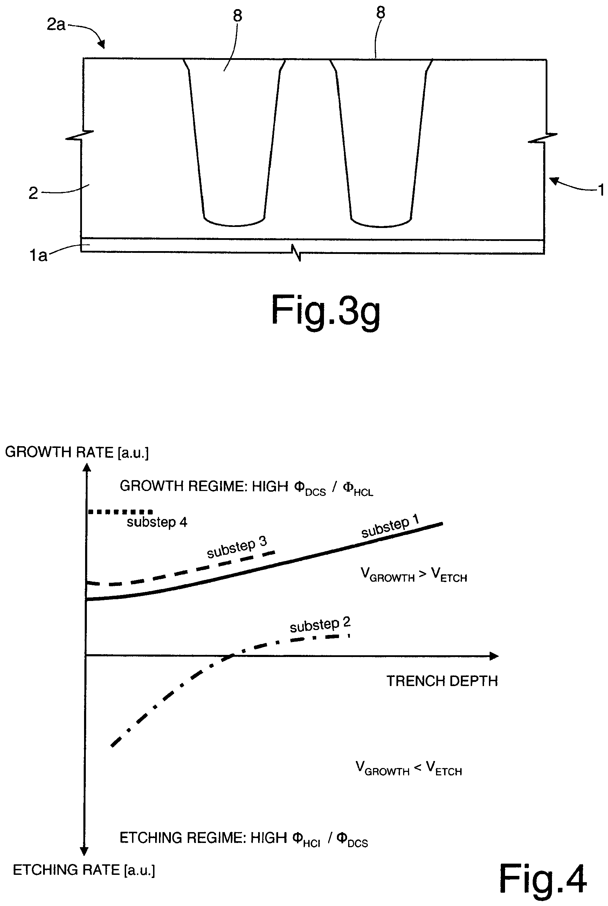

An embodiment envisages in particular that the step of filling by epitaxial growth comprises a sequence of four substeps, highlighted in the plot of Figure 4 in terms of the corresponding rates of growth and etching, each of which is distinct and characterized by an appropriate competitive action between etching and epitaxial growth, given by a corresponding ratio between the flow of HCl and the flow of DCS supplied in the reaction environment (ratio $\Phi_{HCl}/\Phi_{DCS}$).

In detail, during a first substep an average value of the ratio $\Phi_{HCl}/\Phi_{DCS}$ is used comprised between 4 and 9, such as to obtain a rate of growth at the bottom of the deep trench 4 higher than the rate of growth at the top surface 2a of the structural layer 2 (it is to be noted again that the appropriate balance of the reaction species hence enables inversion of the usual profile of epitaxial growth, with a rate of growth at the surface higher than the rate of growth at the bottom). In addition, in this first substep, a higher rate of etching is determined at the top surface 2a, in particular in a lateral direction. In general, during the first substep the process evolves in any case in a growth regime, i.e., with a predominance of the growth of epitaxial material as compared to etching of the grown (and possibly pre-existing) material.

As illustrated in Figure 3c, after the first substep of the filling process, a filling layer 6 of epitaxial silicon, in particular monocrystalline silicon, is formed within the deep trenches 4 and, in a non-selective manner, also on the top surface 2a. The filling layer 6 includes filling regions 6a within each deep trench 4, which coat the internal lateral walls and the bottom thereof.

In particular, thanks to the action of competitive etching exerted by the flow of HCl, the deep trenches 4, and the corresponding filling regions 6a, have a profile that is tapered, flared or funnel-shaped, at the respective opening, narrowing from the surface towards the bottom. Equivalently, the deep trenches 4, and the corresponding filling regions 6a, have side walls with a first inclination, designated by $i_1$, at the surface, and a second inclination, smaller than the first inclination (with respect to the vertical direction, or the direction of the depth), designated by $i_2$, for the remaining part of the same trenches. Etching has in fact a greater effect at the surface than at the bottom of the deep trenches 4, possibly causing also a removal in a lateral direction of a portion of surface material of the structural layer 2 (set between two adjacent deep trenches 4), i.e., of a material existing prior to the epitaxial growth.

In a subsequent second process substep (it is to be noted that the transition from one substep to the next is determined on the basis of the evolution of the shape of the partially filled trench and of the thickness of grown epitaxial silicon, see again Figure 4, a higher value of the $\Phi_{HCl}/\Phi_{DCS}$ ratio is used comprised between 9 and 12 such as to obtain a high effect of etching (and of removal of material) at the top surface 2a of the structural layer 2, and, again, an epitaxial growth at the bottom of the deep trenches 4. In particular, the competitive process evolves into etching regime (i.e., etching is predominant as compared to growth) in a surface region of the deep trenches 4, whilst it evolves into a growth regime (i.e., growth is as a whole predominant as compared to etching) in a deep region of the deep trenches 4.

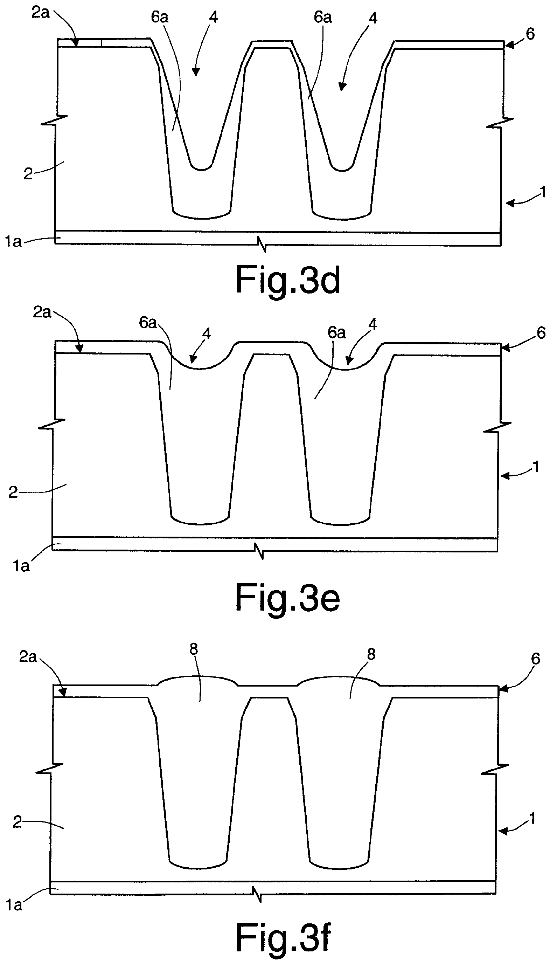

As illustrated in Figure 3d, this process substep entails a remodelling of the deep trenches 4 and of the filling regions 6a within the same deep trenches 4, which assume a "V" profile, i.e., with side walls that have an increased angle of inclination from the surface to the bottom, again considered with respect to the vertical direction (the angle of inclination is, for instance, between 80° and 87°). There occurs in particular an increase in the thickness of the filling regions 6a in an area corresponding to the bottom of the deep trenches 4, and an increase in the width of the mouth of the deep trenches 4 (due to etching in a lateral direction of the epitaxial layer grown, and possibly of the pre-existing surface material of the structural layer 2). Once again, the deep trenches 4 and the corresponding filling regions 6a have a characteristic profile, tapered at the top surface 2a.

In a third process substep, subsequent to the aforesaid second substep (see again Figure 4), conditions of etching/growth substantially equivalent to those used during the first substep are applied, i.e., a ratio $\Phi_{HCl}/\Phi_{DCS}$ of average value and not much less than the one used in the aforesaid first substep comprised between 3 and 8. This ratio determines again a regime of growth throughout the depth of the deep trenches 4 (a depth that in the mean time has clearly decreased, on account of the growth of epitaxial material on the bottom), and a rate of growth at the bottom higher than the rate of growth at the surface.

As illustrated in Figure 3e, the third substep of the filling process causes a substantially complete filling of the deep trenches 4, with the corresponding filling regions 6a that occupy in a way that is uniform and altogether free from voids the inside of the deep trenches 4. At the end of the third substep, the deep trenches 4 may still present a depression at the top surface 2a (i.e., a region not yet filled, of small depth). It is to be noted in particular that this substantially complete and uniform filling is the effect of the appropriate remodelling of the shape of the deep trenches 4 and of the regions of epitaxial growth within the deep trenches 4, during the previous process substeps, as highlighted previously, such as not to cause a premature closing of the fronts of growth from the side walls, before filling has occurred at the bottom.

The process terminates with a fourth substep, of overgrowth, carried out in complete growth regime, i.e., with a ratio $\Phi_{HCl}/\Phi_{DCS}$ of a low value, less than the corresponding values assumed in the previous substeps and comprised between 2 and 4. In particular, a substantially uniform rate of growth is determined throughout the depth of the deep trenches 4 not yet occupied by the corresponding filling regions 6a.

As illustrated in Figure 3f, this substep determines effectively complete filling of the deep trenches 4 and formation of columnar structures 8 within the structural layer 2, constituted by epitaxial material that is uniform, compact, and free from voids. It is to be noted that the columnar structures 8 have a swelling in a region corresponding to the top surface 2a of the structural layer 2.

The filling process terminates with a possible step of surface planarization (CMP - Chemical Mechanical Planarization), as illustrated in Figure 3g, in order to remove the filling layer 6 on the top surface 2a and the aforesaid swellings of the columnar structures 8 and planarize the top surface 2a of the structural layer 2.

At the end of the filling process, the columnar structures 8 have moreover an appropriate level and profile of doping, obtained, as previously mentioned, by supplying a flow of an appropriate dopant species within the same reaction environment as the one in which the epitaxial growth is carried out (the doping of the columnar structures 8 is hence obtained simultaneously with the epitaxial filling of the deep trenches 4, modulated by the concomitant etching of material).

For instance, in a possible embodiment, the columnar structures 8 have a level of doping such as to balance the charge present in the structural layer 2, thus providing charge-balance structures, and moreover have a doping profile that is uniform vertically throughout their depth.

In detail, the doping factor may be expressed as the ratio between the flow of the dopant species (in this case, diborane, $\Phi_{B2H6}$), and the total flow of the remaining species supplied in the reaction environment:

$$\frac{\Phi_{B2H6}}{\Phi_{DCS} + \Phi_{H2} + \Phi_{HCl}} \approx \frac{\Phi_{B2H6}}{\Phi_{H2}} ; \Phi_{H2} >> \Phi_{DCS}, \Phi_{HCl}$$

The doping factor is hence proportional to the flow of diborane, once the value of the flow of carrier gas necessary for the reaction of epitaxial growth has been established (it is to be noted that the flow of the carrier gas, $\Phi_{H2}$, is considerably greater than the individual flows $\Phi_{DCS}$ and $\Phi_{HCl}$; for instance, flows $\Phi_{DCS}$ and $\Phi_{HCl}$ of approximately 1 1 correspond to a flow $\Phi_{H2}$ of approximately 30 1).

In addition, given the competitive reaction between $B_2H_6$ and HCl, which tends to render the concentration of dopant in the reaction environment deplete, one aspect of the present invention envisages regulation of the flow of $B_2H_6$ as a function also of the flow of HCl.

In particular, in order to maintain a distribution of dopant uniform within the columnar structures 8, the flows are regulated in such a way that the ratio $\Phi_{B2H6}/\Phi_{HCl}$ (i.e., the ratio between the flow of the dopant species and the flow of the etching agent) remains constant during the entire filling process (and during the corresponding four process substeps), notwithstanding the variation in the ratio $\Phi_{HCl}/\Phi_{DCS}$, for the reasons described previously of modulation of epitaxial growth. Basically, the flow of $B_2H_6$ is varied and regulated as a function of the flow of HCl, in a way corresponding thereto.

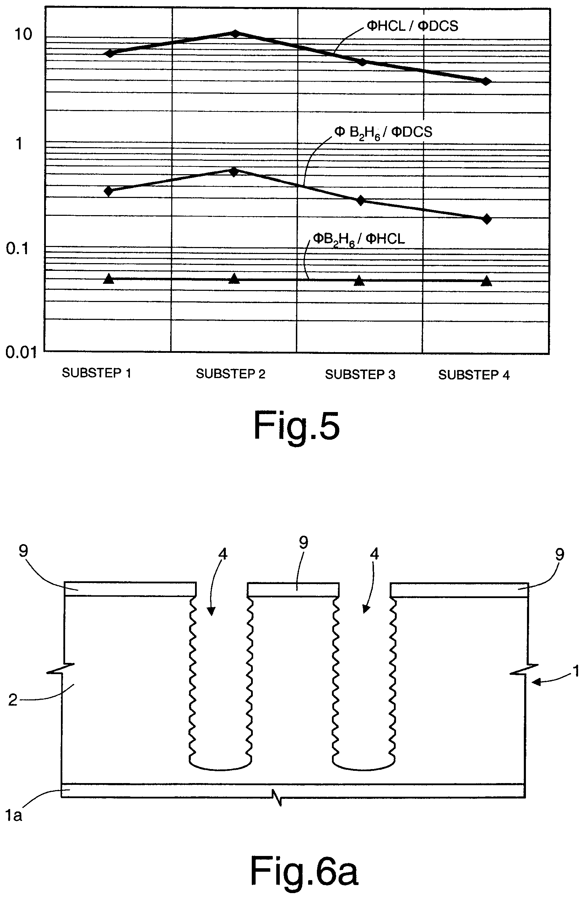

Figure 5 illustrates the profile of the values of the aforesaid ratios of flows, during the four substeps of the process of filling the deep trenches 4; in particular, it is highlighted that the ratio $\Phi_{B2H6}/\Phi_{HCl}$ remains effectively constant in order to obtain a uniform doping profile of the columnar structures 8, and the ratios $\Phi_{B2H6}/\Phi_{DCS}$ and $\Phi_{HCl}/\Phi_{DCS}$ have substantially corresponding trends.

Evidently, it is, however, possible to obtain different doping profiles, according to the specific manufacturing requirements, by appropriately varying the flow of the dopant species within the reaction environment during the process of filling of the deep trenches 4.

A different embodiment of the filling process envisages a selective growth of the epitaxial material, limited to the deep trenches 4 alone (the epitaxial growth does not, instead, involve the top surface 2a of the structural layer 2).

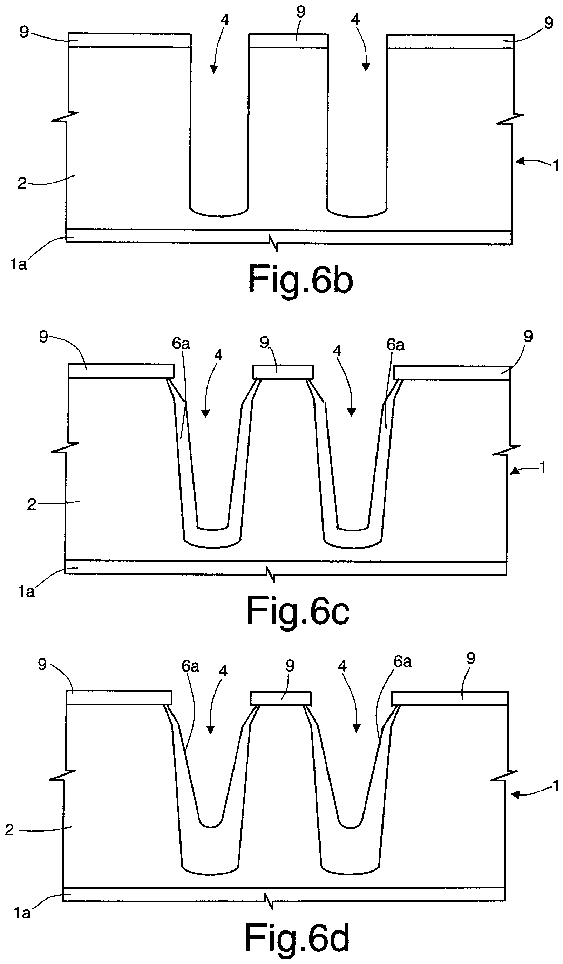

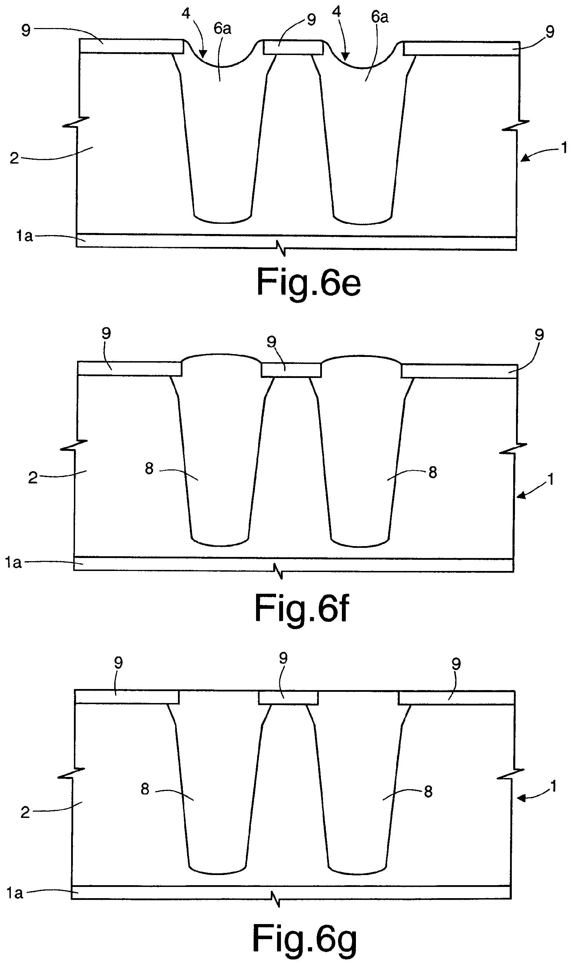

For this purpose, as illustrated in Figures 6a-6g, which represent the sequence of the substeps of the filling process (not described again in detail), in an initial step of the process, a mask (so-called "hard mask") layer 9 is formed on the top surface 2a of the structural layer 2 (Figure 6a); the mask layer 9 is made, for example, of silicon oxide or silicon nitride, acting as "stopping layer", i.e., having the function of stopping the steps of etching and growth outside the deep trenches 4. The mask layer 9 in fact coats the top surface 2a, leaving only the deep trenches 4, and in particular the corresponding mouths at the top surface 2a, exposed. Evidently, the mask layer 9 may be present prior to the deep trenches 4 and be used as etching mask for forming the same deep trenches 4. Advantageously (see Figure 6g), the mask layer 9 acts as stopping layer for the CMP process, preventing in particular any undesirable over-etching of the underlying structural layer 2.

In addition, as illustrated once again in Figure 6g, the mask layer 9 remains on the top surface 2a of the structural layer 2 also at the end of the planarization process (which, in this case, involves the sole swellings of the columnar structures 8), thus constituting a mask of a hard-mask type also for the subsequent steps of the manufacturing process.

In this regard, at the end of the process of filling of the deep trenches 4 and of formation of the columnar structures 8, the manufacturing process proceeds with formation, at least in part within the structural layer 2 and using the same columnar structures 8, of a semiconductor device, for instance a semiconductor power device, such as a power MOSFET. In particular, the pitch of the structure of the power device is defined by the periodicity of the process of definition and filling of the deep trenches 4.

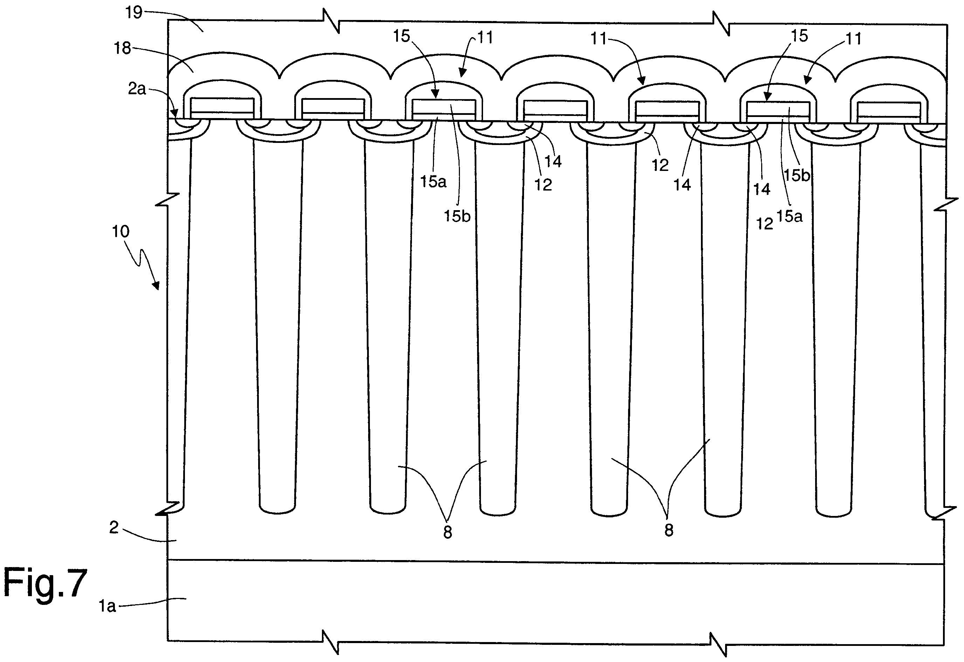

Figure 7 shows, by way of example, a power MOSFET device, designated by 10, provided with techniques in themselves known, and for this reason not described in detail herein.

The power MOSFET device 10, of a planar type, has a periodic-strip structure given by the repetition of a plurality of elementary transistors 11, each of which includes: a body well 12, with a doping of a P type, arranged at the top surface 2a, in direct contact with a respective columnar structure 8 (which constitutes the extension thereof in the drain region, which is in turn constituted by the structural layer 2); source regions 14, with a doping of an N type, arranged within the body well 12; and an insulated-gate structure 15, which is in turn formed by the superposition of a silicon-oxide region 15a and a polysilicon region 15b, set at least partially above a source region 14 and extending between two adjacent body wells 12 of the power MOSFET device 10.

A passivation layer 18 and a metallization layer 19 are arranged, in a known way, on the top surface 2a of the structural layer 2 and of the insulated-gate structures 15.

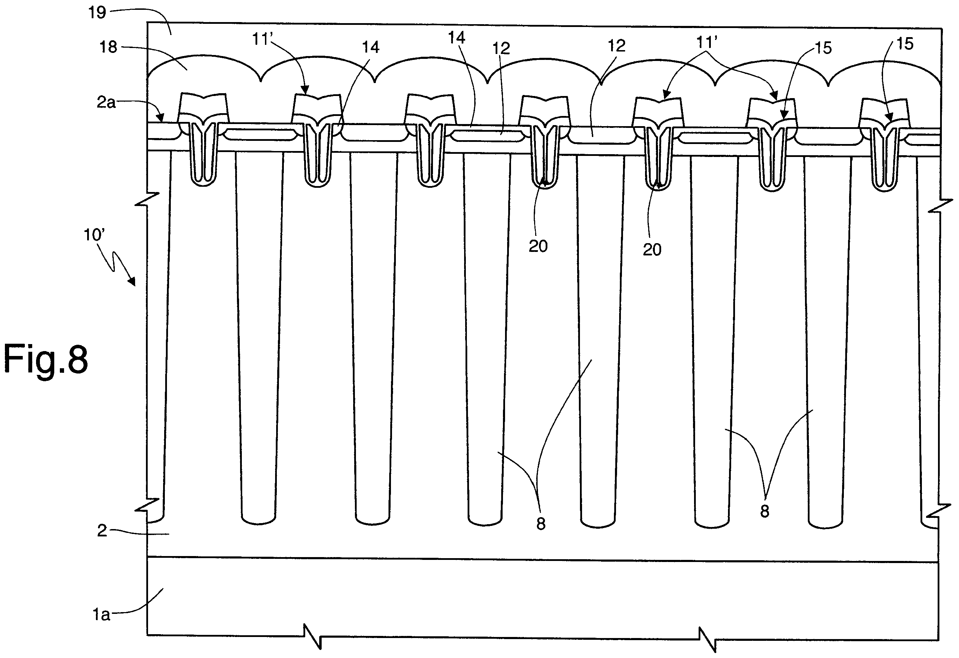

Figure 8 shows a variant of the power MOSFET device, designated here by 10', including a plurality of elementary transistors 11'.

In this case, the insulated-gate structures 15 are provided within gate trenches 20 dug in surface portions of the structural layer 2 arranged between adjacent columnar structures 8. The body wells 12, with a doping of a P type, are formed by a doped surface layer, traversed periodically by the gate trenches 20; source regions 14, with a doping of an N type, are again arranged within the body wells 12, just as the passivation layer 18 and the metallization layer 19 are also in this case arranged on the top surface 2a of the structural layer 2 and of the insulated-gate structures 15 (as shown in the aforesaid Figure 8).

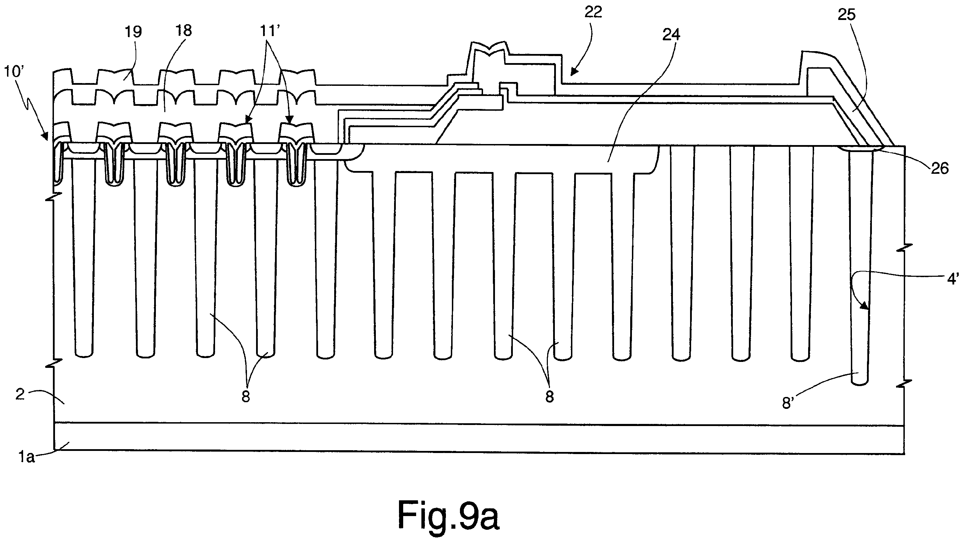

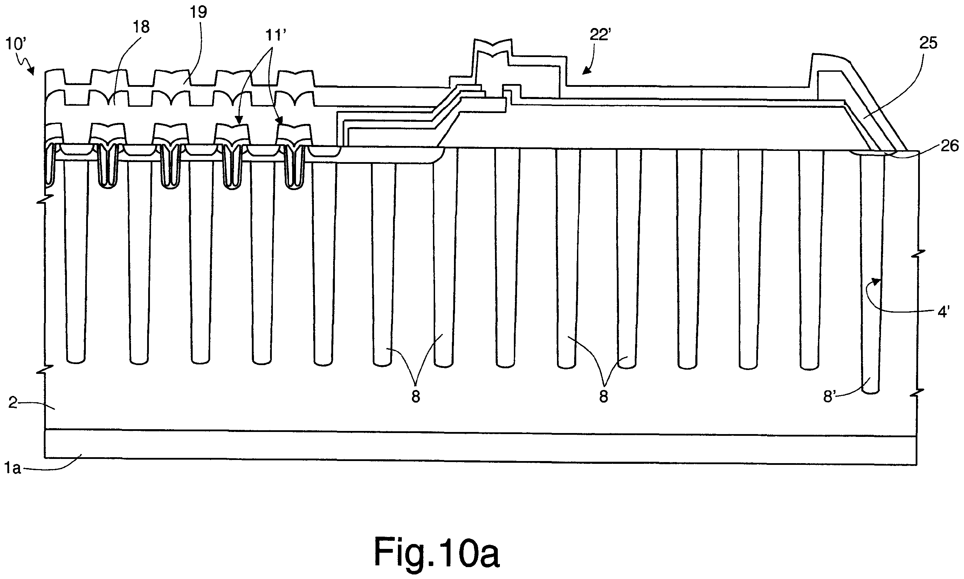

Due to effects of termination of the structure and "loading" effects during the etching steps of the manufacturing process, the last deep trench, designated by 4' in the subsequent Figures 9a and 10a, of the device (i.e., the trench set closest to the scribe line) may be wider and/or deeper. Consequently, it may happen that, during the filling process, defects are formed (in particular one or more residual voids) within this terminal trench.

To prevent problems, it may be hence convenient not to use this last deep trench 4', and the corresponding last columnar structure, designated by 8' once again in Figures 9a and 10a, in an active way in the resulting semiconductor device, in effect rendering the trench a "dummy" trench.

In addition, it is convenient to prevent the field lines in reverse biasing from reaching this last columnar structure 8', in particular by providing an appropriate edge-termination structure.

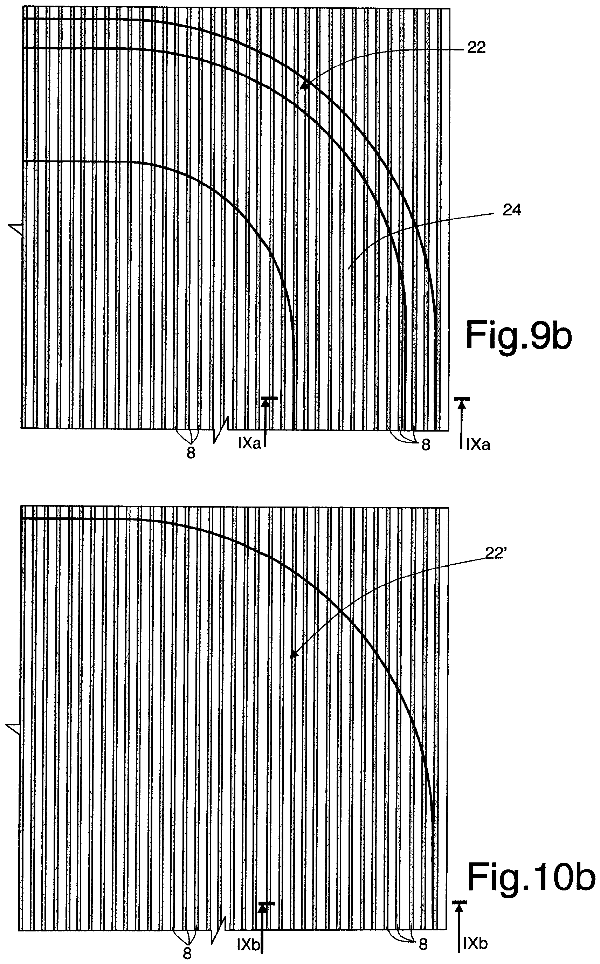

Figures 9a and 9b show (indicatively and not in scale), by way of example, a cross section and a simplified top plan view, respectively, of a portion of an edge structure, designated as a whole by 22, of the power MOSFET device 10' described with reference to Figure 8 (similar considerations clearly apply to the power MOSFET device 10 of Figure 7 or to other semiconductor devices that may be provided by including the columnar structures 8, as part of the same devices).

In a similar way, Figures 10a and 10b show (indicatively and not in scale) a cross section and a simplified top plan view, respectively, of a portion of an edge structure, designated as a whole by 22', of the power MOSFET device 10' described with reference to Figure 8, in a different embodiment.

The edge structures 22, 22' are discussed in detail in the Italian patent application No. IT1397574 B1 filed on December 29, 2008 in the name of the present applicant.

The two embodiments shown in Figures 9a-9b and in Figures 10a-10b, respectively, are distinguished in that: in the former there is a surface ring 24, with a low-concentration doping of a P type, which connects some of the columnar structures 8 set in a region corresponding to the edge-termination structure 22; whilst in the latter embodiment, this surface ring is absent, and all the columnar structures 8 are floating. In either case, the edge-termination structure 22, or 22' prevents the field lines from reaching the last columnar structure 8' (which has a greater depth in the case shown).

It is noted moreover that an EQR (Equipotential Ring) metallization 25 contacts a doped region 26, in particular a doped region having conductivity of an N type, provided in the surface portion of the structural layer 2, in contact with the aforesaid last columnar structure 8'. The doped region 26 surrounds the entire device and has the function of bringing to the surface the drain potential, so as to horizontally limit electric field lines in reverse biasing.

The advantages of the manufacturing process according to the present invention emerge evidently from the foregoing description.

It is emphasized in any case that this process enables a complete filling, free from residual defectiveness, of deep trenches that have high aspect ratios. For instance, the columnar structures resulting from the uniform filling may have a depth of 30 $\mu$m by a width of between 1.5 $\mu$m and 3 $\mu$m; or else a depth of 10 $\mu$m by a width of between 0.5 $\mu$m and 1.5 $\mu$m.

In addition, the process is fast (given that it envisages a concomitant step of epitaxial growth, etching for modulation of the epitaxial growth, and doping) and inexpensive to implement; in particular, the number of process steps is lower as compared to conventional technologies, for instance, current multidrain (MD) technology.

The distribution of the dopant (as well as the dopant species) within the columnar structures formed at the end of the filling process may be modulated according to the specific applicational requirements; for instance, it may be constant throughout the depth of the columnar structure or may have an appropriate concentration gradient.

In one embodiment, the columnar structures are doped uniformly so as to obtain a charge balance with the doping of the structural layer through which the columnar structures extend, so as to form multidrain or superjunction devices.

Outside the epitaxially filled columnar structures (i.e., in the conduction area, for example, having a doping of an N type), the dopant profile is without gradient; in fact, the dopant introduced is confined in the region of the deep trenches, which are to be filled epitaxially, and moreover the device is produced with minimal thermal budget, seeing that the columnar structures are the result of a single epitaxial process, which leads to the formation of intrinsically continuous and uniform columnar structures, without requiring additional thermal processes. The constant dopant profile in the conduction area advantageously enables reduction in the conduction resistance ($R_{on}$) per unit area.

In addition, the manufacturing process is compatible with a wafer of large dimensions (for example 8" or 12"), and enables periodic structures pitches of low value, for example less than 8 $\mu$m, to be obtained. The process moreover facilitates increase in the voltage class of the resulting devices, and can, for example, be applied to power devices with breakdown voltage that ranges from 50 V to 2000 V, according to the initial depth of the trenches.

In general, the process described enables improvement of the reliability and quality of the resulting semiconductor devices.

Finally, it is clear that modifications and variations may be made to what has been described and illustrated herein, without thereby departing from the scope of the present invention, as defined by the annexed claims.

In particular, it is evident that some of the features of the substeps of epitaxial growth and concomitant etching of the material grown (and possibly of the pre-existing material), in which the process of filling of the deep trenches is divided, can vary with respect to what has been illustrated; for instance the duration of the same steps, may vary. The process can in fact be modulated and adapted to various and specific requirements and applications.

As already emphasized, also the flow of the dopant species in the reaction environment for epitaxial growth may vary, so as to obtain different and in any case controlled doping profiles (possibly even ones that include different dopant species).

In addition, it is evident that modifications may be made also from the structural standpoint: for instance, the deep trenches (and the corresponding columnar structures) may extend as far as the underlying substrate and partially within the substrate itself; the semiconductor devices provided may equivalently have P channels or N channels, just as the columnar structures can have doping of an N type, instead of a P type.

As already emphasized, the process of filling of the deep trenches can find advantageous application in a wide range of fields, apart for the manufacturing of semiconductor power devices; for example, via a columnar structure resulting from the filling process described (which in this case can envisage filling even of just one deep trench), a sinker can be provided for a semiconductor device, designed to bring to the surface the potential of a buried region (for example, a drain region).

**Claims**

1. A process for manufacturing a semiconductor device (10; 10'), comprising the steps of:

   - providing a semiconductor material body (2) having at least one deep trench (4), which extends through said body of semiconductor material starting from a top surface (2a) thereof; and
   - filling said deep trench (4) via an epitaxial growth of semiconductor material, thereby forming a columnar structure (8) within said semiconductor material body (2),

   wherein said step of filling comprises introducing, in a reaction environment for epitaxial growth, a flow of a source gas for said epitaxial growth;
   wherein said step of filling further comprises the step of modulating said epitaxial growth by means of a concurrent chemical etching of the semiconductor material that is undergoing epitaxial growth, so as to obtain a compact filling free from voids of said deep trench (4),
   wherein said step of modulating said epitaxial growth comprises introducing, in the same reaction environment as that of the epitaxial growth, a flow of an etching gas, designed to mix with said flow of source gas;
   wherein said step of modulating said epitaxial growth comprises a plurality of substeps, each of which distinguished by a respective ratio between said flow of etching gas and said flow of source gas supplied in said reaction environment for the epitaxial growth, wherein said plurality of substeps comprises:

   - a first substep, distinguished by a ratio between 4
   and 9 between said flow of etching gas and said flow of source gas supplied in said reaction environment for the epitaxial growth, said first substep carried out in growth regime throughout the depth of said deep trench (4) and such as to cause a rate of growth of said semiconductor material that is higher at the bottom of said deep trench (4), set at a distance from said top surface (2a), than at said top surface (2a) ;

- a second substep, subsequent to said first substep, distinguished by a ratio between 9 and 12 between said flow of etching gas and said flow of source gas supplied in said reaction environment for the epitaxial growth, said second substep carried out in etching regime for a portion of said deep trench (4) set in the proximity of said top surface (2a), and such as to cause a rate of etching of said semiconductor material that is higher at said top surface (2a) than at said bottom of said deep trench (4); and

- a third substep, subsequent to said second substep, distinguished by a ratio between 3 and 8 between said flow of etching gas and said flow of source gas supplied in said reaction environment for the epitaxial growth, said third substep carried out in growth regime throughout the depth of said deep trench (4), and such as to cause a substantially complete filling of said deep trench (4);

- a fourth substep, subsequent to said third substep, distinguished by a ratio between 2 and 4 between said flow of etching gas and said flow of source gas supplied in said reaction environment for the epitaxial growth, said fourth substep carried out in growth regime throughout a residual depth of said deep trench (4), which remains following upon said third substep, and such as to cause a complete filling of said deep trench (4) and formation of said columnar structure (8) within said body of semiconductor material (2); the process for manufacturing a semiconductor device further comprising the step of doping said columnar structure (8); said doping step comprising the step of introducing in said reaction environment for the epitaxial growth a flow of a dopant gas to carry out doping of said semiconductor material that is undergoing epitaxial growth, said flow of dopant gas being designed to mix with said flow of source gas and with said flow of etching gas in the same reaction environment as that of said epitaxial growth;

wherein said semiconductor material is silicon, said source gas is dichlorosilane (DCS - $SiH_2Cl_2$), and said etching gas is hydrochloric acid (HCl).

2. The process for manufacturing a semiconductor device (10; 10') according to claim 1, wherein said step of doping said columnar structure (8) comprises, during said epitaxial growth, varying said flow of dopant gas as a function of a variation of said flow of etching gas in such a way as to take into account an effect of depletion of said dopant gas caused by said etching gas.

3. The process for manufacturing a semiconductor device (10; 10') according to claim 2, wherein said doping step comprises doping with a uniform profile said columnar structure (8) throughout a depth thereof; and wherein said step of varying comprises varying said flow of dopant gas in a way corresponding to the variation of said flow of etching gas, during said epitaxial growth.

4. The process for manufacturing a semiconductor device (10; 10') according to any of the preceding claims, wherein said dopant gas is diborane ($B_2H_6$).

5. The process for manufacturing a semiconductor device (10; 10') according to any one of the preceding claims, further comprising, prior to said step of filling, the step of forming a mask layer (9) on said top surface (2a) of said body of semiconductor material (2), said mask layer (9) having an opening in an area corresponding to said deep trench (4); and wherein said filling step is carried out in the presence of said mask layer (9) in such a way that said epitaxial growth occurs in a selective way within said deep trench (4).

6. The process for manufacturing a semiconductor device (10; 10') according to any one of the preceding claims, wherein, at the end of said step of providing said body of semiconductor material (2), said body of semiconductor material (2) has a plurality of deep trenches (4), extending therethrough starting from said top surface (2a); and said step of filling comprises filling, with the same epitaxial growth of semiconductor material, said deep trenches (4), in such a way as to form a plurality of columnar structures (8) within said body of semiconductor material (2), having a doping such as to balance an amount of charge, of an opposite type, of said body of semiconductor material (2).

7. The process for manufacturing a semiconductor device (10; 10') according to claim 6, further comprising the step of forming at least one device region (12), having a given doping, set in direct contact with a respective one of said columnar structures (8).

8. The process for manufacturing a semiconductor device (10; 10') according to claim 7, wherein said semiconductor device (10; 10') is a charge-balance power device, chosen from among a MOSFET, an IGBT, and a bipolar transistor.

**Patentansprüche**

1. Verfahren zum Herstellen einer Halbleitervorrichtung (10; 10'), das folgende Schritte aufweist:

   - Bereitstellen eines Halbleitermaterialkörpers (2) mit mindestens einem tiefen Graben (4), der sich ausgehend von einer oberen Oberfläche (2a) durch den Halbleitermaterialkörper hindurch erstreckt; und
   - Füllen des tiefen Grabens (4) über ein epitaxiales Wachstum von Halbleitermaterial, um dadurch eine säulenartige Struktur (8) in dem Halbleitermaterialkörper (2) zu bilden,

   wobei der Füllschritt das Einbringen eines Stroms von Quellgas für das epitaxiale Wachstum in eine Reaktionsumgebung für das epitaxiale Wachstum beinhaltet;
   wobei der Füllschritt ferner den Schritt des Modulierens des epitaxialen Wachstums mittels eines gleichzeitigen chemischen Ätzvorgangs des Halbleitermaterials beinhaltet, das das epitaxiale Wachstum durchläuft, um dadurch eine kompakte Füllung frei von Hohlräumen in dem tiefen Graben (4) zu erhalten,
   wobei der Schritt des Modulierens des epitaxialen Wachstums das in die gleiche Reaktionsumgebung wie für das epitaxiale Wachstum erfolgende Einbringen eines Stroms eines Ätzgases beinhaltet, der zum Mischen mit dem Strom des Quellgases ausgebildet ist;
   wobei der Schritt des Modulierens des epitaxialen Wachstums eine Mehrzahl von Unterschritten aufweist, von denen jeder durch ein jeweiliges Verhältnis zwischen dem Strom des Ätzgases und dem Strom des Quellgases zu unterscheiden ist, die in die Reaktionsumgebung für das epitaxiale Wachstum eingebracht werden, wobei die Mehrzahl von Unterschritten aufweist:

   - einen ersten Unterschritt, der sich durch ein Verhältnis zwischen 4 und 9 zwischen dem Strom des Ätzgases und dem Strom des Quellgases unterscheidet, die in die Reaktionsumgebung für das epitaxiale Wachstum eingebracht werden, wobei der erste Unterschritt in einem Wachstumssystem durch die gesamte Tiefe des tiefen Grabens (4) sowie derart ausgeführt wird, dass eine Wachstumsrate des Halbleitermaterials hervorgerufen wird, die am Boden des tiefen Grabens (4), der in einer Distanz von der oberen Oberfläche (2) vorgegeben ist, höher ist als an der oberen Oberfläche (2a);
   - einen zweiten Unterschritt, der sich an den ersten Unterschritt anschließt und sich durch ein Verhältnis zwischen 9 und 12 zwischen dem Strom des Ätzgases und dem Strom des Quellgases unterscheidet, die in die Reaktionsumgebung für das epitaxiale Wachstum eingebracht werden, wobei der zweite Unterschritt in einem Ätzsystem für einen Bereich des tiefen Grabens (4), der in der Nähe der oberen Oberfläche (2a) vorgegeben ist, sowie derart ausgeführt wird, dass eine Ätzrate des Halbleitermaterials hervorgerufen wird, die an der oberen Oberfläche (2a) höher ist als an dem Boden des tiefen Grabens (4); und
   - einen dritten Unterschritt, der sich an den zweiten Unterschritt anschließt und sich durch ein Verhältnis zwischen 3 und 8 zwischen dem Strom des Ätzgases und dem Strom des Quellgases unterscheidet, die in die Reaktionsumgebung für das epitaxiale Wachstum eingebracht werden, wobei der dritte Unterschied in einem Wachstumssystem durch die gesamte Tiefe des tiefen Grabens (4) sowie derart ausgeführt wird, dass ein im Wesentlichen vollständiges Füllen des tiefen Grabens (4) veranlasst wird;
   - einen vierten Unterschritt, der sich an den dritten Unterschritt anschließt und sich durch ein Verhältnis zwischen 2 und 4 zwischen dem Strom des Ätzgases und dem Strom des Quellgases unterscheidet, die in die Reaktionsumgebung für das epitaxiale Wachstum eingebracht werden, wobei der vierte Unterschritt in einem Wachstumssystem durch eine gesamte verbleibende Tiefe des tiefen Grabens (4) ausgeführt wird, die nach dem dritten Unterschritt verbleibt, sowie derart ausgeführt wird, dass ein vollständiges Füllen des tiefen Grabens (4) sowie ein Bilden der säulenartigen Struktur (8) innerhalb des Halbleitermaterialkörpers veranlasst werden;

   wobei das Verfahren zum Herstellen einer Halbleitervorrichtung ferner den Schritt des Dotierens der säulenartigen Struktur (8) aufweist;
   wobei der Dotierschritt den Schritt des Einbringens eines Stroms eines Dotierstoffgases in die Reaktionsumgebung für das epitaxiale Wachstum beinhaltet, um die Dotierung des Halbleitermaterials auszuführen, das dem epitaxialen Wachstum unterzogen wird, wobei der Strom des Dotierstoffgases dazu ausgebildet ist, sich mit dem Strom des Quellgases sowie mit dem Strom des Ätzgases in der gleichen Reaktionsumgebung wie der des epitaxialen Wachstums zu mischen;
   wobei das Halbleitermaterial Silizium ist, das Quellgas Dichlorsilan (DCS-$SiH_2Cl_2$) ist und das Ätzgas Salzsäure (HCl) ist.

2. Verfahren zum Herstellen einer Halbleitervorrichtung (10; 10') nach Anspruch 1, wobei der Schritt des Dotierens der säulenartigen Struktur (8) beinhaltat, dass während des epitaxialen Wachstums der Strom des Dotierstoffgases in Abhängigkeit von einer Änderung des Stroms des Ätzgases in einer derartigen Weise variiert wird, dass ein Effekt der Verarmung des Dotierstoffgases aufgrund des Ätzgases berücksichtigt wird.

3. Verfahren zum Herstellen einer Halbleitervorrichtung (10; 10') nach Anspruch 2, wobei der Schritt des Dotierens eine Dotierung der säulenartigen Struktur (8) mit einem gleichmäßigen Profil über die gesamte Tiefe derselben beinhaltet; und wobei der Schritt des Variierens das Variieren des Stroms des Dotierstoffgases während des epitaxialen Wachstums in einer Weise beinhaltet, die der Änderung des Stroms des Ätzgases entspricht.

4. Verfahren zum Herstellen einer Halbleitervorrichtung (10; 10') nach einem der vorhergehenden Ansprüche, wobei das Dotierstoffgas Diboran ist ($B_2H_6$).

5. Verfahren zum Herstellen einer Halbleitervorrichtung (10; 10') nach einem der vorhergehenden Ansprüche, das ferner vor dem Füllschritt den Schritt des Bildens einer Maskenschicht (9) auf der oberen Oberfläche (2a) des Halbleitermaterialkörpers (2) beinhaltet, wobei die Maskenschicht (9) eine Öffnung in einem dem tiefen Graben (4) entsprechenden Bereich aufweist; und wobei der Füllschritt in der Gegenwart der Maskenschicht (9) in einer derartigen Weise ausgeführt wird, dass das epitaxiale Wachstum in dem tiefen Graben (4) in selektiver Weise stattfi ndet.

6. Verfahren zum Herstellen einer Halbleitervorrichtung (10; 10') nach einem der vorhergehenden Ansprüche, wobei am Ende des Schrittes der Bereitstellung des Halbleitermaterialkörpers (2) der Halbleitermaterialkörper (2) eine Mehrzahl von tiefen Gräben (4) aufweist, die sich von der oberen Oberfläche (2a) durch diesen hindurch erstrecken; und wobei der Füllschritt das mit dem gleichen epitaxialen Wachstum des Halbleitermaterials erfolgende Füllen der tiefen Gräben (4) in einer derartigen Weise, dass eine Mehrzahl von säulenartigen Strukturen (8) innerhalb des Halbleitermaterialkörpers (2) gebildet wird, sowie mit einer derartigen Dotierung beinhaltet, dass ein Ladungsbetrag eines entgegengesetzten Typs des Halbleitermaterialkörpers (2) ausgeglichen wird.

7. Verfahren zum Herstellen einer Halbleitervorrichtung (10; 10') nach Anspruch 6, das ferner des Schritt des Bildens von mindestens einem Vorrichtungsbereich (12) beinhaltet, der eine bestimmte Dotierung aufweist und in direktem Kontakt mit einer jeweiligen der säulenartigen Strukturen (8) vorgesehen wird.

8. Verfahren zum Herstellen einer Halbleitervorrichtung (10; 10') nach Anspruch 7, wobei die Halbleitervorrichtung (10; 10') eine Ladungsausgleichs-Leistungsvorrichtung ist, die ausgewählt wird aus einem MOSFET, einem IGBT und einem Bipolartransistor.

**Revendications**

1. Processus pour fabriquer un dispositif à semi-conducteurs (10 ; 10'), comprenant les étapes :

- de fourniture d'un corps de matériau semi-conducteur (2) comportant au moins une tranchée profonde (4), qui s'étend à travers ledit corps de matériau semi-conducteur en commençant à partir d'une surface supérieure (2a) de celui-ci ; et
- de remplissage de ladite tranchée profonde (4) par une croissance épitaxiale du matériau semi-conducteur, formant de ce fait une structure colonnaire (8) dans ledit corps de matériau semi-conducteur (2),

dans lequel ladite étape de remplissage comprend l'introduction, dans un environnement de réaction pour une croissance épitaxiale, d'un écoulement d'un gaz de source pour ladite croissance épitaxiale ; dans lequel ladite étape de remplissage comprend en outre l'étape de modulation de ladite croissance épitaxiale au moyen d'une gravure chimique simultanée du matériau semi-conducteur qui subit la croissance épitaxiale, de manière à obtenir un remplissage compact exempt de vides de ladite tranchée profonde (4), dans lequel ladite étape de modulation de ladite croissance épitaxiale comprend l'introduction, dans le même environnement de réaction que celui de la croissance épitaxiale, d'un écoulement d'un gaz de gravure, destiné à être mélangé avec ledit écoulement de gaz de source ; dans lequel ladite étape de modulation de ladite croissance épitaxiale comprend une pluralité d'étapes secondaires, chacune se distinguant par un rapport respectif entre ledit écoulement de gaz de gravure et ledit écoulement de gaz de source fourni dans ledit environnement de réaction pour la croissance épitaxiale, dans lequel ladite pluralité d'étapes secondaires comprend :

- une première sous-étape, se distinguant par un rapport entre 4 et 9 entre ledit écoulement de gaz de gravure et ledit écoulement de gaz de source fourni dans ledit environnement de réaction pour la croissance épitaxiale, ladite première étape secondaire étant effectuée dans un régime de croissance dans toute la profondeur de ladite tranchée profonde (4) et de manière à faire en sorte qu'une vitesse de croissance dudit matériau semi-conducteur soit plus élevée au niveau du fond de ladite tranchée profonde (4), placé à une distance de ladite surface supérieure (2a), qu'au niveau de ladite surface supérieure (2a) ;

- une deuxième sous-étape, à la suite de ladite première sous-étape, se distinguant par un rapport entre 9 et 12 entre ledit écoulement de gaz de gravure et ledit écoulement de gaz de source fourni dans ledit environnement de réaction pour la croissance épitaxiale, ladite deuxième étape secondaire étant effectuée dans un régime de gravure pour une partie de ladite tranchée profonde (4) placée à proximité de ladite surface supérieure (2a), et de manière à faire en sorte qu'une vitesse de gravure dudit matériau semi-conducteur soit plus élevée au niveau de ladite surface supérieure (2a) qu'au niveau dudit fond de ladite tranchée profonde (4) ; et

- une troisième sous-étape, à la suite de ladite deuxième sous-étape, se distinguant par un rapport entre 3 et 8 entre ledit écoulement de gaz de gravure et ledit écoulement de gaz de source fourni dans ledit environnement de réaction pour la croissance épitaxiale, ladite troisième étape secondaire étant effectuée dans un régime de croissance dans toute la profondeur de ladite tranchée profonde (4), et de manière à réaliser un remplissage sensiblement complet de ladite tranchée profonde (4) ;

- une quatrième sous-étape, à la suite de ladite troisième sous-étape, se distinguant par un rapport entre 2 et 4 entre ledit écoulement de gaz de gravure et ledit écoulement de gaz de source fourni dans ledit environnement de réaction pour la croissance épitaxiale, ladite quatrième étape secondaire étant effectuée dans un régime de croissance dans toute la profondeur résiduelle de ladite tranchée profonde (4), qui subsiste à la suite ladite troisième sous-étape, et de manière à réaliser un remplissage complet de ladite tranchée profonde (4) et la formation de ladite structure colonnaire (8) dans ledit corps de matériau semi-conducteur (2) ;

le processus pour fabriquer un dispositif à semi-conducteurs comprenant en outre l'étape de dopage de ladite structure colonnaire (8) ;

ladite étape de dopage comprenant l'étape d'introduction, dans ledit environnement de réaction pour la croissance épitaxiale, d'un écoulement d'un gaz dopant pour effectuer le dopage dudit matériau semi-conducteur qui subit la croissance épitaxiale, ledit écoulement de gaz dopant étant destiné à être mélangé avec ledit écoulement de gaz de source et avec ledit écoulement de gaz de gravure dans le même environnement de réaction que celui de ladite croissance épitaxiale ;

dans lequel ledit matériau semi-conducteur est le silicium, ledit gaz de source est le dichlorosilane (DCS-$SiH_2Cl_2$), et ledit gaz de gravure est l'acide chlorhydrique (HCl).

2. Processus pour fabriquer un dispositif à semi-conducteurs (10 ; 10') selon la revendication 1, dans lequel ladite étape de dopage de ladite structure colonnaire (8) comprend, pendant ladite croissance épitaxiale, la modification dudit écoulement de gaz dopant en fonction d'une modification dudit écoulement de gaz de gravure de manière à prendre en compte un effet d'appauvrissement dudit gaz dopant provoqué par ledit gaz de gravure.

3. Processus pour fabriquer un dispositif à semi-conducteurs (10 ; 10') selon la revendication 2, dans lequel ladite étape de dopage comprend le dopage avec un profil uniforme de ladite structure colonnaire (8) dans toute la profondeur de celle-ci ; et dans lequel ladite étape de modification comprend la modification dudit écoulement de gaz dopant d'une manière correspondant à la modification dudit écoulement de gaz de gravure, pendant ladite croissance épitaxiale.

4. Processus pour fabriquer un dispositif à semi-conducteurs (10 ; 10') selon l'une quelconque des revendications précédentes, dans lequel ledit gaz dopant est le diborane ($B_2H_6$).

5. Processus pour fabriquer un dispositif à semi-conducteurs (10 ; 10') selon l'une quelconque des revendications précédentes, comprenant en outre, avant ladite étape de remplissage, l'étape de formation d'une couche de masque (9) sur ladite surface supérieure (2a) dudit corps de matériau semi-conducteur (2), ladite couche de masque (9) comportant une ouverture dans une zone correspondant à ladite tranchée profonde (4) ; et dans lequel ladite étape de remplissage est effectuée en présence de ladite couche de masque (9) de manière à ce que ladite croissance épitaxiale se produise d'une manière sélective dans ladite tranchée profonde (4).

6. Processus pour fabriquer un dispositif à semi-conducteurs (10 ; 10') selon l'une quelconque des revendications précédentes, dans lequel, à la fin de ladite étape de fourniture dudit corps de matériau semi-conducteur (2), ledit corps de matériau semi-conducteur (2) comporte une pluralité de tranchées profondes (4), s'étendant à travers celui-ci en commençant par ladite surface supérieure (2a) ; et ladite étape de remplissage comprend le remplissage, avec la même croissance épitaxiale de matériau semi-conducteur, desdites tranchées profondes (4), de manière à former une pluralité de structures colonnaires (8) dans ledit corps de matériau semi-conducteur (2), ayant un dopage tel qu'il équilibre une quantité de charge, de type opposé, dudit corps de matériau semi-conducteur (2).

7. Processus pour fabriquer un dispositif à semi-conducteurs (10 ; 10') selon la revendication 6, comprenant en outre l'étape de formation d'au moins une région de dispositif (12), ayant un dopage donné, placée en contact direct avec l'une respective desdites structures colonnaires (8).

8. Processus pour fabriquer un dispositif à semi-conducteurs (10 ; 10') selon la revendication 7, dans lequel ledit dispositif à semi-conducteurs (10 ; 10') est un dispositif de puissance à équilibrage de charges, choisi parmi un transistor MOSFET, un IGBT et un transistor bipolaire.

BV

excess of charge of N type    0    excess of charge of P type

| Nd - Na |

## Fig.1

GROWTH RATE [ a.u.]

$V_{GROWTH} > V_{ETCH}$

TRENCH DEPTH

## Fig.2

Fig.3a

Fig.3b

Fig.3c

Fig.3d

Fig.3e

Fig.3f

**Fig.3g**

**Fig.4**

Fig.5

Fig.6a

Fig.6b

Fig.6c

Fig.6d

Fig.6e

Fig.6f

Fig.6g

Fig.7

EP 2 599 107 B1

Fig.8

**Fig.9a**

EP 2 599 107 B1

Fig.10a

EP 2 599 107 B1

Fig.9b

Fig.10b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6586798 B
- US 6228719 B
- US 6300171 B
- US 6404010 B
- IT 1397574 B1

### Non-patent literature cited in the description

- **YAMAUCHI S et al.** 200V Fabrication of high aspect ratio doping region by using trench filling of epitaxial SI growth. *PROCEEDINGS OF THE 13TH INTERNATIONAL SYMPOSIUM ON POWER SEMICONDUCTOR DEVICES,* 04 June 2001, 363-366
- 200V super junction MOSFET fabricated by high aspect ratio trench filling. **YAMAUCHI S et al.** PROCEEDINGS OF THE 18TH INTERNATIONAL SYMPOSIUM ON POWER SEMICONDUCTOR DEVICES & ICS. IEEE, 2006, 4